## Europäisches Patentamt

## European Patent Office

## Office européen des brevets

(19)

(11) Veröffentlichungsnummer: **0 278 254**
**B1**

(12)

# EUROPÄISCHE PATENTSCHRIFT

(45) Veröffentlichungstag der Patentschrift:
**13.06.90**

(51) Int. Cl.⁵: **G01N 24/08**

(21) Anmeldenummer: **88100524.3**

(22) Anmeldetag: **15.01.88**

(54) Gerät zur Ermittlung von kernmagnetischen Spektren aus räumlich selektierbaren Bereichen eines Untersuchungsobjektes.

(30) Priorität: **30.01.87 DE 3702820**

(43) Veröffentlichungstag der Anmeldung:
**17.08.88 Patentblatt 88/33**

(45) Bekanntmachung des Hinweises auf die Patenterteilung:
**13.06.90 Patentblatt 90/24**

(84) Benannte Vertragsstaaten:
**DE GB NL**

(56) Entgegenhaltungen:
EP-A- 0 106 226
EP-A- 0 153 703
WO-A-85/00887

JOURNAL OF MAGNETIC RESONANCE, Band 70, Dezember 1986, Seiten 488-492, Academic Press, Inc., New York, US; J. GRANOT: "Selected volume excitation using stimulated echoes (VEST). Applications to spatially localized spectroscopy and imaging"
JOURNAL OF MAGNETIC RESONANCE, Band 67, März 1986, Seiten 148-155, Academic Press, Inc., New York, US; P.R. LUYTEN et al.: "Solvent-suppressed spatiallyresolved spectroscopy. An approach to high-resolution NMR on a whole-body MR system"
JOURNAL OF MAGNETIC RESONANCE, Band 59,

(73) Patentinhaber: **Siemens Aktiengesellschaft, Wittelsbacherplatz 2, D-8000 München 2(DE)**

(72) Erfinder: **Oppelt, Arnulf, Dr., Schwedenstrasse 25, D-8521 Spardorf(DE)**
Erfinder: **Hentschel, Dietmar, Dr., Stegerstrasse 6, D-8522 Niederndorf(DE)**
Erfinder: **Ladebeck, Ralf, Dipl.-Phys., Anton-Bruckner-Strasse 34a, D-8520 Erlangen(DE)**
Erfinder: **Klose, Uwe, Dipl.-Phys., Hermannstrasse 1, D-3300 Braunschweig(DE)**

(56) Entgegenhaltungen: (Fortsetzung)
September 1984, Seiten 338-342, Academic Press, Inc., New York, US; P.A. BOTTOMLEY et al.: "Depth-resolved surface-coil spectroscopy (DRESS) for in Vivo 1 H, 31P, and 13C NMR"

## Beschreibung

Die Erfindung betrifft ein Gerät zur Ermittlung von kernmagnetischen Spektren aus räumlich selektierbaren Bereichen eines Untersuchungsobjektes mit Grundfeldspulen, die das Untersuchungsobjekt mit einem magnetischen Grundfeld beaufschlagen, Gradientenspulen, die das Untersuchungsobjekt mit Gradientenfeldern beaufschlagen, mit einem HF-Sender, der das Untersuchungsobjekt über eine Antenne mit einer Folge von HF-Impulsen beaufschlagt und mit einem HF-Empfänger, der das entstehende Kernresonanzsignal empfängt und einem Auswerterechner zuführt, wobei zur Untersuchung durch Aufschaltung eines Gradienten zusammen mit einem frequenzselektiven HF-Impuls selektiv eine Schicht des Untersuchungsobjektes zur kernmagnetischen Resonanz angeregt wird.

Bei der kernmagnetischen Spektroskopie wird im allgemeinen eine Abgrenzung auf einzelne Volumenbereiche, z.B. ein Organ, angestrebt. Bei einem aus dem Artikel von P.A. Bottomley und anderen im "Journal of Magnetic Resonance", Band 59, 1984, Seiten 338 bis 342 bekannten Verfahren, wird hierzu eine Schicht des Untersuchungsobjektes durch Aufschaltung eines Gradienten zusammen mit einem frequenzselektiven Anregimpuls angeregt. Damit ist nur eine eindimensionale Ortsauflösung möglich. Eine weitere Selektion kann durch Einsatz von Oberflächenspulen durchgeführt werden, die aus der selektierten Schicht wiederum einen ihrem Empfindlichkeitsbereich entsprechenden Anteil auswählen.

Aufgabe der Erfindung ist es, ein Gerät der eingangs genannten Art so auszuführen, daß eine exaktere Ortsauflösung möglich wird, wobei die Hochfrequenz-Belastung für das Untersuchungsobjekt gering bleiben soll. Diese Aufgabe wird erfindungsgemäß dadurch gelöst, daß durch aufeinanderfolgende Einschaltung von HF-Sender und Gradientenspulen folgende Anregungs- bzw. Ausleseschritte durchgeführt werden:

a) Durch einen ersten, nichtselektiven 90°-HF-Impuls wird die Magnetisierung des Untersuchungsobjektes aus der durch das Grundmagnetfeld vorgegebenen z-Richtung in eine dazu senkrecht liegende x-y-Ebene gedreht.

b) Ein erster, selektiver 180°-HF-Impuls wird zusammen mit einem ersten magnetischen Gradienten eingestrahlt, wobei der erste magnetische Gradient eine Dephasierung der Spins außerhalb einer ersten selektierten Schicht bewirkt.

c) Ein zweiter, selektiver 180°-HF-Impuls wird zusammen mit einem zweiten, auf dem ersten senkrecht stehenden magnetischen Gradienten eingestrahlt, wobei der zweite magnetische Gradient eine Dephasierung der Spins außerhalb einer zweiten selektierten Schicht bewirkt.

d) Ein zweiter, selektiver 90°-HF-Impuls wird zusammen mit einem dritten, auf dem ersten und zweiten senkrecht stehenden magnetischen Gradienten eingestrahlt, wobei der dritte magnetische Gradient die Spins in einem selektierten Voxel wieder parallel zur Anfangslage bringt.

e) Ein dritter 90°-HF-Impuls wird eingestrahlt und das darauf vom Untersuchungsobjekt ausgesandte Signal ausgewertet.

Mit einem derartigen Gerät ist eine volle dreidimensionale Ortsauflösung möglich, wobei die HF-Belastung des Untersuchungsobjektes gering bleibt, da nur zwei selektive 180°-HF-Impulse und drei 90°-HF-Impulse notwendig sind.

Vorteilhafte Ausgestaltungen der Erfindung sind in den Unteransprüchen angegeben.

Ein Ausführungsbeispiel der Erfindung wird nachfolgend anhand der FIG 1 bis 10 näher erläutert.

FIG 1 zeigt schematisch den Aufbau eines Kernspin-Resonanzgerätes,
FIG 2 zeigt die Sequenz der HF-Impulse, mit denen das Untersuchungsobjekt beaufschlagt wird,
FIG 3 zeigt den Verlauf des Gradienten $G_z$,
FIG 4 zeigt den Verlauf des Gradienten $G_y$,
FIG 5 zeigt den Verlauf des Gradienten $G_x$,
FIG 6 zeigt den Verlauf des ausgelesenen Signals S,
FIG 7 zeigt die Auswahl der einzelnen Schichten und die
FIG 8 bis 10 zeigen das mit dem beschriebenen Gerät erzielte Spektrum eines Phantoms.

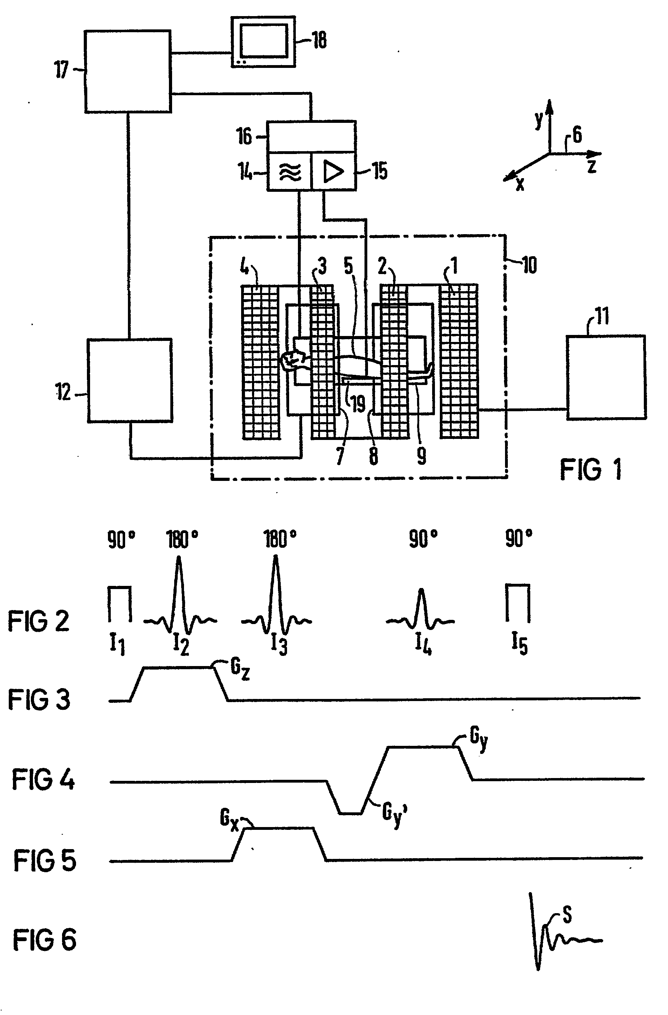

FIG 1 zeigt schematisch den prinzipiellen Aufbau eines Kernspin-Resonanzgerätes zur Ermittlung von Spektren eines Untersuchungsgerätes. Mit 1 und 2 sowie 3 und 4 sind Spulen bezeichnet, die ein magnetisches Grundfeld B0 erzeugen, in welchem sich bei medizinischer Anwendung der zu untersuchende Körper 5 eines Patienten befindet. Diesem sind außerdem Gradientenspulen zugeordnet, die zur Erzeugung unabhängiger, zueinander senkrechter Magnetfeldgradienten der Richtungen x,y und z gemäß dem Koordinatenkreuz 6 vorgesehen sind. In der FIG sind der Übersichtlichkeit halber nur die Gradientenspulen 7 und 8 gezeichnet, die zusammen mit einem Paar gegenüberliegender, gleichartiger Gradientenspulen zur Erzeugung eines Gradienten in x-Richtung dienen. Die gleichartigen, nicht gezeichneten Gradientenspulen, zur Erzeugung eines Gradienten in y-Richtung liegen parallel zum Körper 5 und oberhalb sowie unterhalb von ihm, die für das Gradientenfeld in z-Richtung quer zu seiner Längsachse am Fuß- und am Kopfende. Die Anordnung enthält außerdem noch einen zur Erzeugung der Kernresonanzsignale dienenden Körper-Resonator 9 als Antenne. Zur Aufnahme der Kernresonanzsignale kann auch noch eine Oberflächenspule 19 vorgesehen sein.

Die von einer strichpunktierten Linie 10 umgrenzten Spulen 1, 2,3,4,7,8 und 9 stellen das eigentliche Untersuchungsinstrument dar. Es wird von einer elektrischen Anordnung aus betrieben, die ein Netzgerät 11 zum Betrieb der Spulen 1 bis 4 sowie eine Gradientenstromversorgung 12, an welcher die Gradientenspulen 7 und 8 sowie die weiteren Gradientenspulen anliegen, umfaßt. Ein von einem Prozeßrechner 17 gesteuerter Hochfrequenzsender 14 ist mit dem Körperresonator 9 verbunden. Die Oberflächenspule 19 ist über einen Signalverstärker 15 ebenfalls an den Prozeßrechner 17 gekoppelt, an dem zur Ausgabe eines Spektrums ein Bildschirmgerät 18 angeschlossen ist. Die Komponenten 14 und 15 bilden eine Hochfrequenzeinrichtung 16 zur Signalerzeugung und -aufnahme.

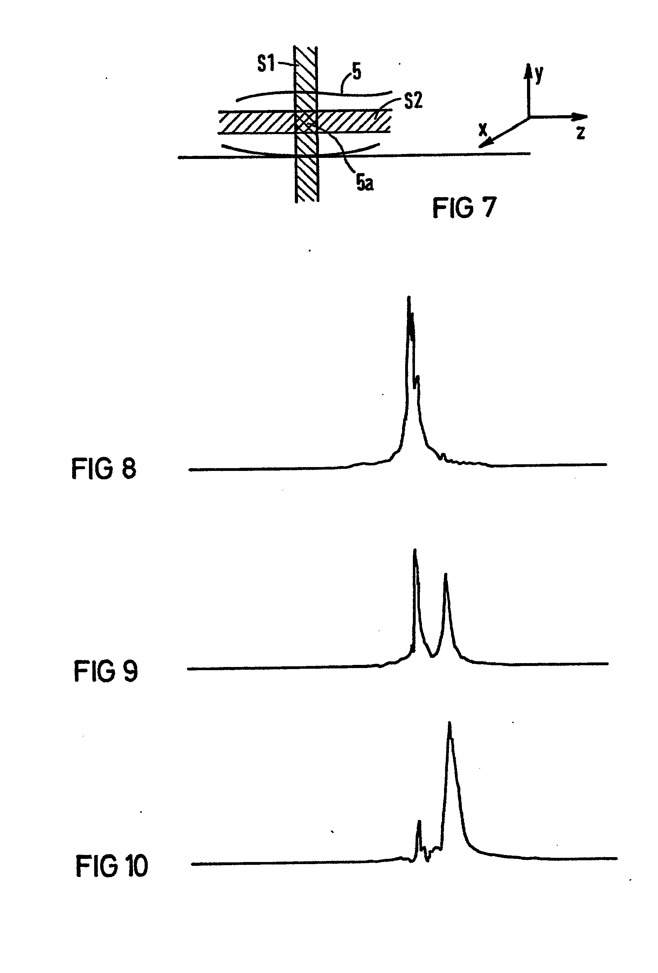

Anhand der FIG 2 bis 6 wird im folgenden die Anregesequenz dargestellt. Die Magnetisierung im Untersuchungsbereich liegt aufgrund des Grundmagnetfeldes zunächst in z-Richtung. Durch einen nichtselektiven 90°-HF-Impuls, der in FIG 2 mit $I_1$ bezeichnet ist, wird die Magnetisierung im gesamten Untersuchungsraum zunächst in die x-y-Ebene gedreht. Anschließend wird ein selektiver 180°-HF-Impuls $I_2$ mit vorgegebener Frequenz gleichzeitig mit einem Gradienten $G_z$ eingestrahlt. Durch den Gradienten $G_z$ und die Frequenz des ersten, selektiven 180°-HF-Impulses $I_2$ wird eine in FIG 7 mit $S_1$ bezeichnete Schicht ausgewählt, in der der selektive 180°-HF-Impuls wirksam wird und dort alle Spins um 180° dreht. Außerhalb dieser Schicht $S_1$ dephasieren die Spins aufgrund des Gradienten $G_z$, da sie eine unterschiedliche Präzisionsfrequenz aufweisen.

Anschließend wird ein zweiter, selektiver 180°-HF-Impuls $I_3$ zusammen mit einem Gradienten $G_x$ eingestrahlt, der ebenfalls selektiv in einer Schicht $S_2$ wirkt, die senkrecht zur ersten Schicht $S_1$ steht. Dabei werden wiederum aufgrund des Gradienten $G_x$ alle Spins außerhalb der Schicht $S_2$ dephasiert. Somit bleiben lediglich die Spins in einem Quader, der durch den Schnitt der beiden Schichten $S_1$ und $S_2$ gebildet wird, in Phase.

Schließlich wird ein zweiter, selektiver 90°-HF-Impuls $I_4$ zusammen mit einem Gradienten $G_y$ eingestrahlt. Damit werden in einer in FIG 7 nicht dargestellten, zu den Schichten $S_1$ und $S_2$ senkrecht stehenden dritten Schicht die Spins um 90° gedreht. Dies bedeutet für die in einem Voxel, das durch den Schnitt der drei Schichten bestimmt ist, liegenden Spins, daß diese zur Z-Achse gedreht werden. Wenn der erste, nichtselektive 90°-HF-Impuls $I_1$ und der selektive 90°-HF-Impuls $I_4$ dasselbe Vorzeichen aufweisen, so liegen die Spins in diesem Voxel nunmehr in Richtung -z, wenn die 90°-HF-Impulse entgegengesetztes Vorzeichen aufweisen, so liegen sie in +z-Richtung.

Durch den während des selektiven 90°-HF-Impulses aufgeschalteten Gradienten $G_y$ erfolgt ebenfalls eine unerwünschte Dephasierung der Spins. Diese Dephasierung kann durch einen vorher aufgeschalteten Gradientenimpuls $G_y'$ kompensiert werden, der zum Gradientenimpuls $G_y$ entgegengesetztes Vorzeichen aufweist. Die Kompensation kann auch vor den selektiven 180°-HF-Impulsen $I_2$ oder $I_3$ aufgeschaltet werden, wobei jedoch zu berücksichtigen ist, daß jeder 180°-HF-Impuls die Wirkung invertiert. Vor dem ersten 180°-HF-Impuls $I_2$ müßte daher ebenfalls ein negativer Gradientenimpuls $G_y'$, vor dem zweiten 180°-HF-Impuls $I_3$ ein positiver Gradientenimpuls $G_y'$ aufgeschaltet werden.

Die Reihenfolge der dargestellten Gradienten ist hier nur beispielhaft und kann beliebig vertauscht werden.

Nach der dargestellten Anregung liegen nur die Spins des selektierten Voxels in z-Richtung. Wenn man nunmehr den Untersuchungsraum mit einem nichtselektiven 90°-HF-Impuls $I_5$ beaufschlagt, erhält man als Antwort ein in FIG 6 dargestelltes HF-Signal S, das nur von dem selektierten Voxel herrührt.

Durch eine geringfügige Verzögerung zwischen dem selektiven 90°-HF-Impuls $I_4$ und dem nichtselektiven 90°-HF-Impuls $I_5$ kann erreicht werden, daß Wirbelströme, die durch die Aufschaltung der Gradienten verursacht werden, vor der Signalauswertung abgefallen sind.

Wenn aufgrund von Inhomogenitäten die Magnetisierung außerhalb des Voxels durch den ersten, nichtselektiven 90°-HF-Impuls $I_1$ nicht vollständig in die x-y-Ebene gedreht worden ist oder aufgrund kurzer $T_1$-Relaxationszeiten nach der Volumenselektion bereits ein Teil der Magnetisierung wieder in die z-Richtung zurückgekehrt ist, so kann die dadurch entstehende Unschärfe der Ortsselektion durch Anwendung zweier aufeinanderfolgender Anregungssequenzen kompensiert werden. Dazu wird die dargestellte Anregungssequenz zweimal durchgeführt, wobei der selektive 90°-HF-Impuls $I_4$ einmal in x-Richtung und einmal in -x-Richtung eingestrahlt wird. Dadurch hat die Magnetisierung des Voxels jeweils entgegengesetztes Vorzeichen, während die Restmagnetisierung außerhalb des Voxels jeweils das gleiche Vorzeichen hat. Werden nun die aufgrund der beiden Anregungssequenzen gefundenen Meßergebnisse subtrahiert, so bleibt ausschließlich die Magnetisierung des Voxels erhalten.

Die FIG 8 bis 10 zeigen das Ergebnis einer Demonstration des Selektionsverfahrens an einem Phantom. Dabei wurde in einer Wasserflasche eine zweite Flasche mit Öl befestigt. Das Spektrum nach FIG 8 wurde erhalten, wenn das Voxel ausschließlich in der Wasserflasche lokalisiert ist. Das Spektrum nach FIG 9 wurde erhalten, wenn das Voxel im Grenzbereich der Öl- und Wasserflasche lokalisiert ist und das Spektrum nach FIG 10 wurde erhalten, wenn das Voxel innerhalb der Ölflasche lokalisiert ist. Die zweite Spitze im Spektrum stammt von dem Restwasser im Öl.

**Patentansprüche**

1) Gerät zur Ermittlung von kernmagnetischen Spektren aus räumlich selektierbaren Bereichen (5a) eines Untersuchungsobjektes (5) mit Grundfeldspulen (1 bis 4), die das Untersuchungsobjekt (5) mit einem magnetischen Grundfeld beaufschlagen und Gradientenspulen (7,8), die das Untersuchungsobjekt (5) mit Gradientenfeldern beaufschlagen, mit einem HF-Sender (14), der das Untersuchungsobjekt (5) über eine Antenne (9) mit einer Folge von HF-Impulsen beaufschlagt und mit einem HF-Empfänger (15), der das entstehende Kernresonanzsignal empfängt und einem Auswerterechner (17) zuführt, wobei zur Untersuchung durch Aufschaltung eines Gradienten zusammen mit einem frequenzselektiven HF-Impuls selektiv eine Schicht des Untersuchungsobjektes (5) zur kernmagnetischen Resonanz angeregt wird,

**dadurch gekennzeichnet,**

daß durch aufeinanderfolgende Einschaltung von HF-Sender (14) und Gradientenspulen (7, 8) folgende Anregungs- bzw. Ausleseschritte durchgeführt werden:

a) Durch einen ersten, nichtselektiven 90°-HF-Impuls ($I_1$) wird die Magnetisierung des Untersuchungsobjektes (5) aus der durch das Grundmagnetfeld vorgegebenen z-Richtung in eine dazu senkrecht liegende x-y-Ebene gedreht.

b) Ein erster, selektiver 180°-HF-Impuls ($I_2$) wird zusammen mit einem ersten magnetischen Gradienten ($G_z$) eingestrahlt, wobei der erste magnetische Gradient ($G_z$) eine Dephasierung der Spins außerhalb einer ersten selektierten Schicht ($S_1$) bewirkt.

c) Ein zweiter, selektiver 180°-HF-Impuls ($I_3$) wird zusammen mit einem zweiten, auf dem ersten senkrecht stehenden magnetischen Gradienten ($G_x$) eingestrahlt, wobei der zweite magnetische Gradient ($G_x$) eine Dephasierung der Spins außerhalb einer zweiten selektierten Schicht ($S_2$) bewirkt.

d) Ein zweiter, selektiver 90°-HF-Impuls ($I_4$) wird zusammen mit einem dritten, auf dem ersten und zweiten senkrecht stehenden magnetischen Gradienten ($G_y$) eingestrahlt, wobei der dritte magnetische Gradient ($G_y$) die Spins in einem selektierten Voxel (5a) wieder parallel zur Anfangslage bringt.

e) Ein dritter 90°-HF-Impuls ($I_5$) wird eingestrahlt und das darauf vom Untersuchungsobjekt (5) ausgesandte Signal ausgewertet.

2) Gerät nach Anspruch 1,

**dadurch gekennzeichnet,**

daß vor dem zweiten, selektiven 90°-HF-Impuls ($I_4$) ein Gradientenimpuls ($G_y'$) aufgeschaltet wird, der die Dephasierung kompensiert, die durch den dritten magnetischen Gradienten ($G_y$) hervorgerufen wird.

3) Gerät nach Anspruch 1 oder 2,

**dadurch gekennzeichnet,**

daß zwischen dem zweiten, selektiven 90°-HF-Impuls ($I_4$) und dem dritten 90°-HF-Impuls ($I_5$) eine kurze Pause vorgesehen wird.

4) Gerät nach einem der Ansprüche 1 bis 3,

**dadurch gekennzeichnet,**

daß die Anregesequenz zweimal wiederholt wird, wobei der zweite, selektive 90°-HF-Impuls ($I_4$) bei beiden Anregesequenzen entgegengesetzt gerichtet ist und daß die erhaltenen Meßergebnisse subtrahiert werden.

## Revendications

1. Appareil pour déterminer des spectres de résonance magnétique nucléaire à partir de régions (5a), pouvant être sélectionnées spatialement, d'un objet à examiner (5), comportant des bobines (1, 4) de production d'un champ de base, qui chargent l'objet à examiner (5) avec un champ magnétique de base, et des bobines de gradient (7, 8), qui chargent l'objet à examiner (5) avec des champs irrotationnels, et comportant un émetteur à haute fréquence (14), qui charge l'objet à examiner (5), par l'intermédiaire d'une antenne (9), avec une suite d'impulsions à haute fréquence, et un récepteur à haute fréquence (15), qui reçoit le signal de résonance nucléaire formé et l'envoie à un calculateur d'évaluation (17), auquel cas, pour l'examen, on excite de façon sélective une couche de l'objet à examiner (5) pour qu'elle entre en résonance magnétique nucléaire, au moyen de l'application d'un gradient conjointement avec une impulsion à haute fréquence, sélective du point de vue de la fréquence, caractérisé par le fait qu'on exécute les étapes suivantes d'excitation et de lecture au moyen du branchement successif de l'émetteur à haute fréquence (14) et des bobines de gradient (7, 8):

a) au moyen d'une première impulsion non sélective à haute fréquence à 90° ($I_1$), on fait pivoter l'aimantation de l'objet à examiner (5) depuis la direction (z) prédéterminée par le champ de base magnétique dans un plan x–y perpendiculaire à cette direction,

b) on applique une première impulsion à haute fréquence sélective à 180° ($I_2$) conjointement avec un premier gradient magnétique ($G_z$), le premier gradient magnétique ($G_z$) provoquant un déphasage des spins à l'extérieur d'une première couche sélectionnée ($S_1$),

c) on applique une seconde impulsion sélective à haute fréquence à 180° ($I_3$) conjointement avec un second gradient magnétique ($G_x$) perpendiculaire au premier gradient magnétique, le second gradient magnétique ($G_x$) produisant un déphasage des spins à l'extérieur d'une seconde couche sélectionnée ($S_2$);

d) on applique une seconde impulsion sélective à haute fréquence à 90° ($I_4$) conjointement avec un troisième gradient magnétique ($G_y$) perpendiculaire aux premier et second gradients magnétiques, le troisième gradient magnétique ($G_y$) amenant à nouveau les spins dans une position parallèle à la position initiale, dans un élément de volume (Voxel) sélectionné (5a) du corps,

e) on applique une troisième impulsion à haute fréquence à 90° ($I_5$) et on évalue le signal alors émis par l'objet à examiner (5).

2. Appareil suivant la revendication 1, caractérisé par le fait qu'avant d'appliquer la seconde impulsion sélective à haute fréquence à 90° ($I_4$), on applique une impulsion de gradient ($G_{Y'}$), qui compense le déphasage provoqué par le troisième gradient magnétique ($G_Y$).

3. Appareil suivant la revendication 1 ou 2, caractérisé par le fait qu'on prévoit une courte pause entre la seconde impulsion sélective à haute fréquence à 90° ($I_4$) et la troisième impulsion à haute fréquence à 90° ($I_5$).

4. Appareil suivant l'une des revendications 1 à 3, caractérisé par le fait qu'on répète deux fois la séquence d'excitation, la seconde impulsion sélective à haute fréquence à 90° ($I_4$) étant dirigée dans

des sens opposés lors des deux séquences d'excitation, et qu'on soustrait l'un de l'autre les résultats de mesure obtenus.

**Claims**

1. A device for determining nuclear magnetic spectra from spatially selectable regions (5a) of an examination subject (5), having fundamental coils (1 to 4) which subject the examination subject (5) to a fundamental magnetic field and gradient coils (7, 8) which subject the examination subject (5) to gradient fields, having an RF transmitter (14) which subjects the examination subject (5) to a sequence of RF pulses via an antenna (9) and having an RF receiver (15) which receives the resulting nuclear magnetic resonance signal and supplies it to a computer (17) for evaluation, wherein for examination a slice of the examination subject (5) is selectively excited to generate nuclear magnetic resonance by applying a gradient together with a frequency-selective RF pulse, characterised in that by successive activation of the RF transmitter (14) and gradient coils (7, 8) the following excitation and read-out steps are taken:

a) The magnetisation of the examination subject (5) is rotated out of the z-direction, established by the fundamental magnetic field, into an x–y plane disposed perpendicularly thereto by the application of a first nonselective 90° RF pulse ($I_1$).

b) A first selective 180° RF pulse ($I_2$) is applied simultaneously with a first magnetic gradient ($G_Z$), with the first magnetic gradient ($G_Z$) effecting a dephasing of the spin outside of a first selected slice ($S_1$).

c) A second selective 180° RF pulse ($I_3$) is applied simultaneously with a second magnetic gradient ($G_X$), which is disposed perpendicularly to the first magnetic gradient, with the second magnetic gradient ($G_X$) effecting a dephasing of the spin outside of a second selected slice ($S_2$).

d) A second selective 90° RF pulse ($I_4$) is supplied simultaneously with a third magnetic gradient ($G_Y$), which is disposed perpendicularly relative to the first and second magnetic gradients, the third magnetic gradient ($G_Y$) bringing the spin in a selected voxel (5a) back into parallel with the initial position.

e) A third 90° RF impulse ($I_5$) is applied and the signal emitted by the examination subject (5) in response thereto is evaluated.

2. A device according to claim 1, characterised in that a gradient pulse ($G_Y'$) is applied before applying the second selective 90° RF pulse ($I_4$) which compensates dephasing produced by the third magnetic gradient ($G_Y$).

3. A device according to claim 1 or claim 2, characterised in that there is a short time delay between the second selective 90° RF pulse ($I_4$) and the third 90° RF pulse ($I_5$).

4. A device according to any one of claims 1 to 3, characterised in that the excitation sequence is repeated twice, the second selective 90° RF impulse

($I_4$) being supplied in opposing directions in the two excitation sequences and the measured results obtained being subtracted

FIG 1

FIG 2

FIG 3

FIG 4

FIG 5

FIG 6

FIG 7

FIG 8

FIG 9

FIG 10